(19) Europäisches Patentamt / European Patent Office / Office européen des brevets

(11) **EP 2 351 218 B1**

(12) **FASCICULE DE BREVET EUROPEEN**

(45) Date de publication et mention
de la délivrance du brevet:
**15.08.2012 Bulletin 2012/33**

(51) Int Cl.:
*H03K 3/42* *(2006.01)*    *H03K 3/537* *(2006.01)*
*H01J 49/06* *(2006.01)*

(21) Numéro de dépôt: **09783979.9**

(22) Date de dépôt: **13.10.2009**

(86) Numéro de dépôt international:
**PCT/EP2009/063346**

(87) Numéro de publication internationale:
**WO 2010/057721 (27.05.2010 Gazette 2010/21)**

(54) **SONDE ATOMIQUE TOMOGRAPHIQUE COMPORTANT UN GENERATEUR ELECTRO-OPTIQUE D'IMPULSIONS ELECTRIQUES HAUTE TENSION**

TOMOGRAFIE-ATOMSONDE MIT EINEM ELEKTROOPTISCHEN GENERATOR MIT ELEKTRISCHEN HOCHSPANNUNGSIMPULSEN

TOMOGRAPHY ATOMIC PROBE COMPRISING A HIGH VOLTAGE ELECTRIC PULSE ELECTRO-OPTICAL GENERATOR

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**

(30) Priorité: **21.11.2008 FR 0806550**

(43) Date de publication de la demande:
**03.08.2011 Bulletin 2011/31**

(73) Titulaires:
• **Cameca**
  **92622 Gennevilliers (FR)**
• **Centre National de la Recherche Scientifique**
  **75016 Paris (FR)**

(72) Inventeurs:
• **VURPILLOT, François**
  **F-76000 Rouen (FR)**
• **BOSTEL, Alain**
  **F-27370 La Haye du Theil (FR)**

(74) Mandataire: **Lucas, Laurent Jacques et al**
**Marks & Clerk France**
**Conseils en Propriété Industrielle**
**Immeuble Visium**
**22, Avenue Aristide Briand**
**94117 Arcueil Cedex (FR)**

(56) Documents cités:
**JP-A- 2005 290 510    JP-A- 2006 260 780
JP-A- 2007 273 401**

## Description

L'invention concerne le domaine général des générateurs d'impulsions à haute tension. Elle concerne plus particulièrement les générateurs d'impulsions utilisés pour provoquer l'évaporation des atomes sur un échantillon de matériau placé dans une Sonde Atomique Tomographique en vue de son analyse.

Un example pour une Soude Tomographique est expliqué dans le document JP 2007 273401 A.

Une caractéristique essentielle d'une sonde atomique tomographique, est la valeur de la résolution en masse que l'on peut obtenir avec cette sonde. La résolution en masse d'une Sonde Atomique est une qualité essentielle qui caractérise notamment:

- l'aptitude de la sonde à séparer sans ambiguïté les différents pics de masse des différents isotopes des éléments constituant le matériau à analyser. Cette faculté de discriminer est d'autant plus précieuse qu'elle concerne des pics de masses voisines d'amplitudes très différentes.
- l'aptitude de la sonde à augmenter la précision de mesure de la composition du matériau analysé, un alliage par exemple, en diminuant l'incorporation de bruit de détection au niveau d'un pic de masse correspondant à un élément du matériau analysé.

La résolution en masse s'exprime sous la forme d'un rapport R=m/dm où m représente la masse correspondant au pic (i.e. à l'élément) considéré, et où dm représente la largeur du pic de masse pour une amplitude relative à ce pic donnée. Ainsi par exemple si m est égal à 28 et dm à 0,28 pour h=0,5 (largeur à mi-hauteur), on a R=100 à mi-hauteur.

Par suite le problème posé aux fabricants de telles sondes, qui constituent des spectromètres de masse à temps de vol est d'obtenir la meilleure résolution spectrale possible. L'obtention d'une bonne résolution en masse, passe de manière connue par la maitrise de la vitesse de déplacement des particules de matériau, depuis l'échantillon d'où elles sont arrachées, sous forme ionique généralement, jusqu'au détecteur. Autrement dit le problème posé consiste, de manière connue, à trouver un moyen permettant d'obtenir que les atomes évaporés sous forme d'ions soient arrachés de l'échantillon avec la même énergie potentielle initiale et qu'ils volent ensuite sensiblement à la même vitesse vers le détecteur.

De manière connue également, l'apport d'énergie potentielle nécessaire à l'arrachement de quelques atomes d'une couche atomique de l'échantillon est réalisé par l'application au niveau de la zone d'extraction de l'échantillon (la pointe) d'une impulsion de tension de forte valeur (impulsion à haute tension) dont la durée est en pratique de l'ordre de la nanoseconde. Cette tension, ainsi que la courbure de l'extrémité de l'échantillon sont suffisants pour créer un champ électrique dont l'intensité est suffisante pour obtenir le phénomène "d'évaporation par effet de champ", effet connu de l'homme du métier. Cependant, en pratique, la production d'une impulsion atteignant de manière quasi instantanée le niveau de potentiel théorique requis et conservant constamment ce niveau pendant une durée donnée pour cesser de manière tout aussi instantanée, constitue un réel problème en l'état actuel de la technique. Par suite on produit généralement des impulsions dont la partie supérieure présente une forme approximativement parabolique qui se traduit, lorsqu'on utilise de telles impulsions dans une sonde atomique tomographique, par une dégradation de la résolution en masse. La variation de l'amplitude de l'impulsion appliquée à l'échantillon lors de l'évaporation, puis pendant les premiers nanomètres de la trajectoire des ions émis, se traduit ainsi par l'apparition d'un spectre d'énergie (de vitesse) plus ou moins large au lieu d'une raie d'énergie unique. La capacité dé produire une impulsion rectangulaire de forte amplitude et à fronts raides, conditionne donc la résolution spectrale de la Sonde Atomique.

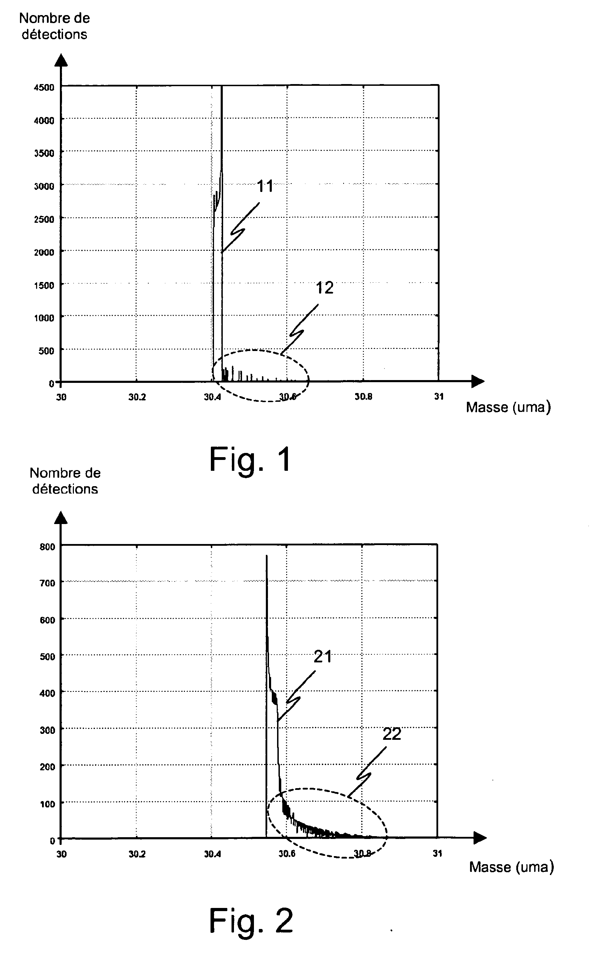

Les figures 1 et 2 illustrent cette dépendance au travers d'histogrammes de masses simulés pour une sonde atomique tomographique ou sonde "Watap" selon l'acronyme de l'expression anglosaxonne "Wide Angle Tomographic Atomic Probe", la sonde simulée ayant une longueur de vol donnée de 0,11 m.

La figure 1 illustre un cas favorable typique, pris comme exemple, où les impulsions d'évaporation sont des impulsions rectangulaires comportant un plateau de 200ps et des fronts de 50ps.

La figure 2 quant à elle illustre le cas moins favorable où les impulsions d'évaporation sont des impulsions rectangulaires comportant un plateau de 200ps et des fronts de 1000ps.

On constate, sur chacune des figures, à la fois la présence d'un pic 11, 21 présentant une certaine largeur ainsi que la présence d'une traine 12, 22 plus étendue mais de niveau moindre. Le pic correspond ici à l'évaporation produite alors que l'impulsion d'évaporation a atteint son niveau maximum (plateau de l'impulsion), tandis que la traine correspond quant à elle à l'évaporation produite pendant les intervalles de temps correspondant aux fronts de montée et de descente, et pour lesquels on constate une perte d'énergie des ions évaporés.

Par suite, sachant que les amplitudes et les durées relatives du pic d'une part et de la traine (partie de l'impulsion située après le pic) d'autre part caractérisent la résolution de la sonde considérée, et que plus l'amplitude du pic est importante et sa largeur faible et plus la résolution de la sonde est grande, on peut constater, au travers de la figure 2, qu'un allongement des temps de montée et de descente de l'impulsion se traduise par une dégradation de la résolution. Autrement dit, plus la forme de l'impulsion d'évaporation se rapproche d'une forme rectangulaire et plus la résolution de la sonde peut être élevée.

Pour limiter ce phénomène, les fabricants cherchent des moyens pour produire des impulsions très brèves (typiquement inférieures à 500ps) un plateau d'amplitude constante et présentant des fronts raides, c'est-à-dire des temps de montée et de descente très courts (typiquement inférieurs à 100ps). L'art antérieur connu propose différentes approches pour réaliser de telles impulsions à haute tension.

On dispose ainsi de dispositifs de génération d'impulsions haute tension utilisant un relais mouillé au mercure. La fréquence de répétition des impulsions produites par de tels dispositifs, de conception relativement ancienne, est cependant extrêmement faible (de l'ordre de la centaine de hertz) au regard des caractéristiques souhaitées, ce qui rend l'analyse de l'échantillon relativement lente.

On dispose également dispositifs semi-conducteurs, de conception plus récente, qui permettent de produire des impulsions de courte durée dont l'amplitude est réglable dans une large plage de tension, typiquement entre une tension voisine de 0V et une tension de 4kV. Ces dispositifs permettent par ailleurs d'obtenir des fréquences de répétition allant jusqu'à quelques dizaines de kilohertz.

Cependant, ces performances sont obtenues au prix d'une dégradation des temps de montée et de descente, c'est-à-dire de la raideur des fronts des impulsions ainsi produites. En l'état actuel de l'art, de tels dispositifs ne permettent donc pas de produire des impulsions rectangulaires de courte durée à haute tension, c'est à dire des impulsions présentant des fronts raides (typiquement inférieurs à 100pS) et un sommet bref (typiquement inférieur à 500ps) et de niveau constant.

On dispose d'autre part de systèmes générateurs d'impulsions capables de produire des impulsions ayant les caractéristiques temporelles voulues, mais une amplitude plus faible et fixe ou difficilement réglable. Ces systèmes sont donc pas ou peu adaptés à une utilisation dans le cadre d'une sonde atomique tomographique qui par nature est destinée à l'analyse de matériaux divers, chaque matériau nécessitant la production d'impulsions dont la valeur de tension est proportionnelle à la haute tension qui polarise l'échantillon.

Aucun dispositif connu de l'art antérieur n'est donc réellement satisfaisant dans le contexte de la production de sondes atomiques à haute résolution en masse.

Un but de l'invention est de répondre au problème spécifique de la production d'impulsions à haute tension ayant les caractéristiques énoncées précédemment et de permettre ainsi une amélioration de la résolution en masse des sondes atomiques tomographiques.

A cet effet l'invention a pour objet une onde atomique tomographique comportant des moyens pour appliquer une impulsion électrique d'évaporation d'amplitude $V_p$, de durée $\Delta t_0$ sur un échantillon porté à un potentiel $V_0$. Selon l'invention, ces moyens comportent:

- une électrode portée à un potentiel initial $V_i$, configurée et agencée pour appliquer l'impulsion électrique sur l'échantillon;

- un générateur de tension capable de produire la tension nécessaire à la production d'une impulsion d'amplitude $V_p$, le générateur de tension étant relié à l'électrode par l'intermédiaire d'une liaison électrique pouvant être ouverte ou fermée;

- des moyens pour commander la fermeture de la liaison électrique en en un temps $\tau$ donné de façon à appliquer un échelon de tension $V_p$ sur l'électrode, ces moyens comportant une pastille de matériau semi-conducteur placée sur la liaison électrique entre le générateur et l'électrode, au voisinage de l'électrode et une première source émettant des impulsions lumineuses de longueur d'onde $\lambda_1$ sur la pastille de semi-conducteur, ladite pastille devenant conductrice et fermant la liaison électrique lorsqu'elle est illuminée par une impulsion lumineuse de longueur d'onde $\lambda_1$, la durée de conduction étant fonction de la durée de l'impulsion lumineuse appliquée;

- des moyens pour appliquer sur l'électrode, au bout d'un temps $\Delta t_0$ après la fermeture de la liaison électrique, un échelon de tension d'amplitude $(-V_p)$ de façon à porter l'électrode au potentiel $V_i$, lesdits moyens étant configurés pour que l'échelon de tension soit appliqué en un temps $\tau'$ sensiblement égal au temps $\tau$.

Selon un mode de réalisation particulier de la sonde atomique tomographique selon l'invention, les moyens pour appliquer sur l'électrode un échelon de tension d'amplitude -Vp au bout d'un temps $\Delta t_0$ après la fermeture du circuit, sont constitués par une ligne de transmission d'impédance caractéristique $Z_c$ reliant le générateur à la pastille, terminée en aval de l'électrode par une impédance égale à $Z_c$.

Selon ce mode de réalisation particulier, la longueur $L_0$ de la ligne de transmission est déterminée par la valeur de l'intervalle de temps $\Delta t_0$ considéré, intervalle de temps égal à la durée de l'impulsion électrique produite.

Selon un autre mode de réalisation particulier de la sonde atomique tomographique selon l'invention, les moyens pour appliquer sur l'électrode au bout d'un temps $\Delta t_0$ après la fermeture du circuit, un échelon de tension d'amplitude -$V_p$ sont constitués par une seconde source émettant des impulsions lumineuses de longueur d'onde $\lambda_2$ sur la pastille de semi-conducteur, ladite pastille devenant isolante et ouvrant la liaison électrique lorsqu'elle est illuminée par une impulsion lumineuse de longueur d'onde $\lambda_2$.

Selon ce mode de réalisation particulier, l'intervalle de temps $\Delta t_0$ séparant l'émission d'une impulsion lumineuse de longueur d'onde $\lambda_1$ de l'émission d'une impulsion lumineuse de longueur d'onde $\lambda_2$, détermine la durée de l'impulsion électrique produite.

Selon un mode de réalisation particulier de la sonde atomique tomographique selon l'invention, l'électrode sur laquelle est produite l'impulsion électrique est positionnée en regard de l'extrémité de l'échantillon au niveau de laquelle l'évaporation est attendue.

Selon un autre mode de réalisation particulier de la sonde atomique tomographique selon l'invention, l'électrode sur laquelle est produite l'impulsion électrique est constituée par l'échantillon lui-même.

Le dispositif selon l'invention permet de former des impulsions électriques, en particulier des impulsions à haute tension, présentant des temps de montée et de descente extrêmement brefs, typiquement de l'ordre de quelques picosecondes. Cette méthode permet aussi de contrôler et de maintenir constante l'amplitude maximale de cette impulsion pendant la durée du plateau. Il permet également de créer des impulsions électriques d'évaporation dont la forme particulière permet d'optimiser la résolution en masse de la Sonde Atomique et notamment de sa variante Grand Angle.

Les caractéristiques et avantages de l'invention seront mieux appréciés grâce à la description qui suit, description qui expose l'invention au travers de modes de réalisation particuliers pris comme exemples non limitatifs et qui s'appuient sur les figures annexées, figures qui présentent:

- les figures 1 et 2, deux histogrammes de masse présentés comme illustrations du problème de résolution posé par les dispositifs de production des impulsions électriques d'évaporation des sondes atomiques existantes;

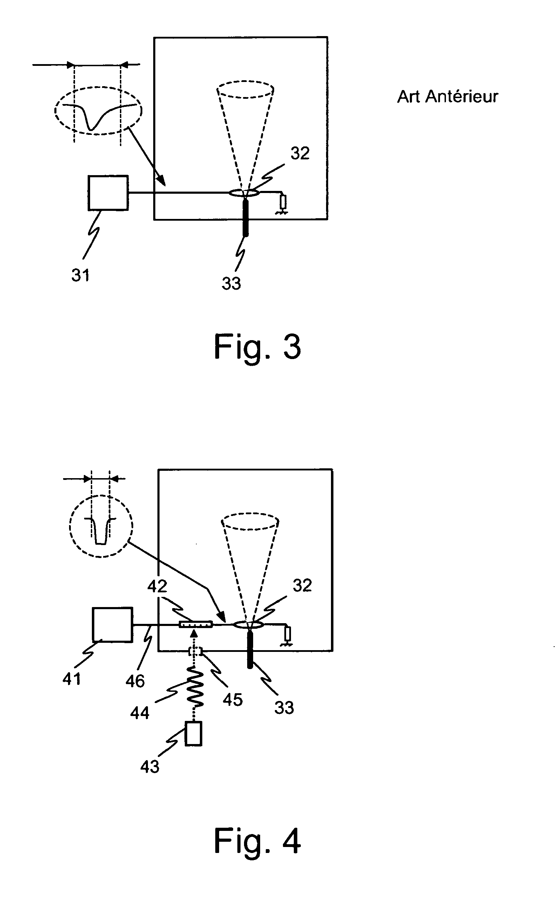

- la figure 3, un schéma de principe illustrant la façon dont les impulsions électriques d'évaporation sont généralement produites dans une sonde atomique selon l'art antérieur connu;

- la figure 4, un schéma de principe analogue au schéma de la figure 3 illustrant au travers d'un mode de réalisation préféré, le principe général de fonctionnement du dispositif selon l'invention;

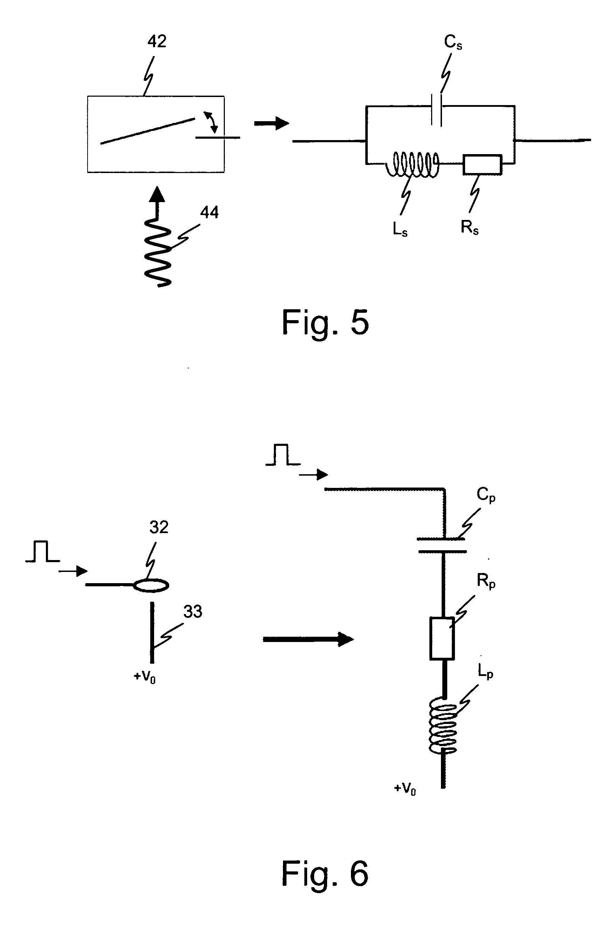

- les figures 5, un schéma équivalent de l'ensemble pointe échantillon - contre-électrode dans une sonde atomique;
- la figure 6, un schéma équivalent de la pastille de semi-conducteur réalisant la fonction d'interrupteur commandé dans le mode de réalisation préféré du dispositif selon l'invention;

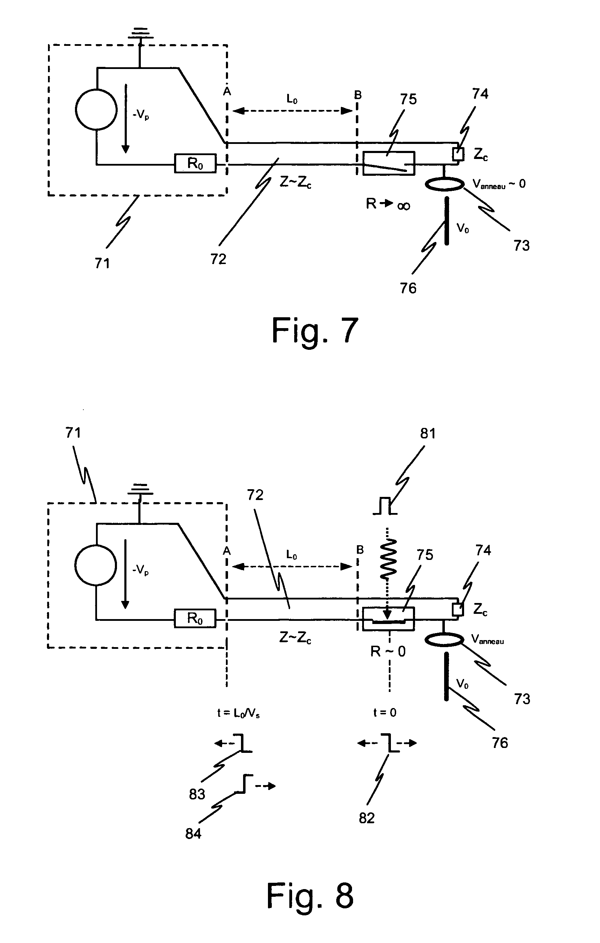

- les figures 7 à 10, des illustrations relatives à une première variante du mode de réalisation préféré du dispositif selon l'invention;

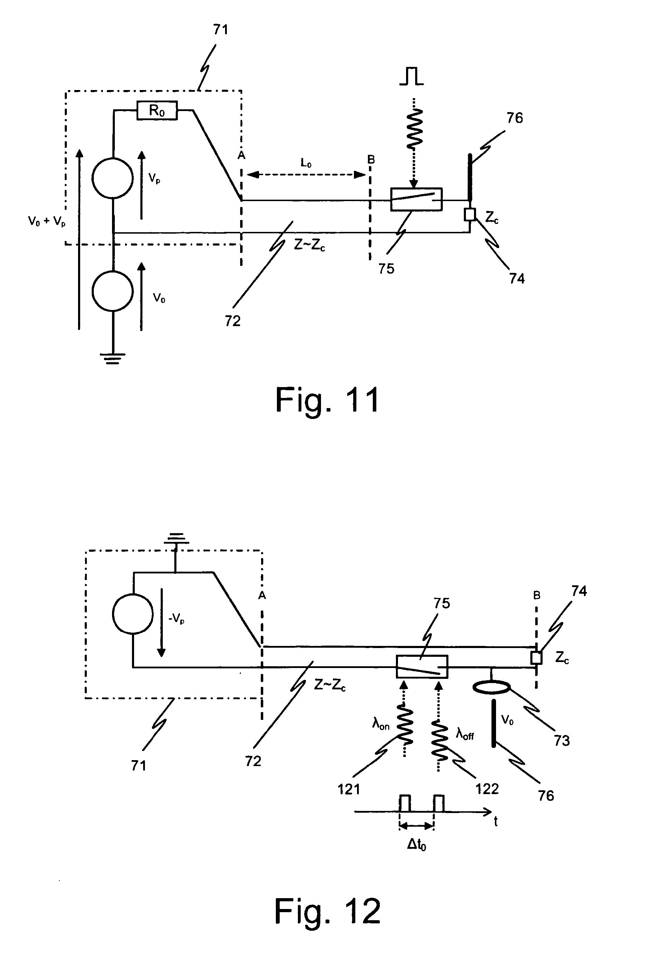

- la figure 11, une illustration relative à une deuxième variante du mode de réalisation préféré du dispositif selon l'invention;
- la figure 12, une illustration relative à une troisième variante du mode de réalisation préféré du dispositif selon l'invention;

Comme l'illustre le schéma de la figure 4, le dispositif générateur d'impulsions électriques selon l'invention comporte en premier lieu un générateur de tension 41 capable de produire la tension nécessaire à la production d'une impulsion d'amplitude $V_2$ au niveau d'une électrode 32, impulsion capable compte tenu du potentiel auquel est porté l'échantillon de provoquer l'évaporation de celui-ci. Ce générateur de tension est relié à l'électrode 32 par l'intermédiaire d'une liaison électrique 46 pouvant être ouverte ou fermée.

Le dispositif selon l'invention comporte également des moyens pour commander la fermeture et l'ouverture de la liaison 46, de façon à appliquer un échelon de tension $V_2$ à l'électrode et porter le potentiel de l'électrode, initialement égal à une valeur $V_1$, à $V_1+V_2$. Les moyens pour commander la fermeture de la liaison 46 comportent un interrupteur commandé, inséré dans le circuit électrique entre le générateur 41 et l'électrode 32, au voisinage de l'électrode, et des moyens pour commander cet interrupteur.

Un mode de réalisation préféré, mais non exclusif, de ces moyens consiste à utiliser une pastille d'un matériau semi-conducteur 42 implantée sur le circuit reliant le générateur de haute tension 41 et l'électrode 32 sur laquelle l'impulsion électrique est appliquée.

Les moyens pour actionner l'interrupteur constitué par la pastille de matériau semi-conducteur 42 sont une source lumineuse 43, une source laser par exemple, délivrant des impulsions brèves 44, inférieures à 100ps typiquement, et de forte intensité. La longueur $\lambda_1$ des impulsions émises par la source lumineuse 43 est déterminée en fonction du semi-conducteur utilisé pour réaliser la pastille 42. L'énergie contenue dans chaque impulsion est par ailleurs suffisante pour mettre la pastille de semi-conducteur en conduction, typiquement de l'ordre de 10 microjoules.

Selon l'invention l'ensemble est agencé de façon à ce que la pastille 42 soit illuminée par la source de lumière 43. A cet effet, les impulsions lumineuses 44 sont appliquées à la pastille de semi-conducteur 42 soit directement à travers un hublot transparent 45, soit par l'intermédiaire d'une fibre optique ou tout autre moyen.

Ainsi, en appliquant une impulsion lumineuse de durée déterminée sur la pastille de matériau semi-conducteur, on fait évoluer naturellement la conduction de la pastille. Dans un premier temps la pastille passe en un bref instant $\tau$ de l'état isolant à l'état conducteur. Elle reste ensuite à l'état conducteur pendant toute la durée de l'impulsion lumineuse. Puis, après extinction de l'impulsion lumineuse, la pastille retourne progressivement, au bout d'un temps $\tau'$, à l'état isolant.

La mis en conduction de la pastille de matériau semi-conducteur se traduit par l'apparition d'un échelon de tension sur l'électrode qui se trouve portée à un potentiel $V_1$. Inversement le retour à l'état isolant de la pastille se traduit par l'apparition d'un échelon de tension inverse au niveau de l'électrode qui se trouve portée au potentiel $V_0$ de repos. On produit ainsi sur l'électrode une impulsion électrique dont la durée dépend de la durée de l'impulsion lumineuse appliquée et des caractéristiques du semi-conducteur constituant la pastille. Une telle impulsion peut donc avantageusement être très brève.

Il est à noter cependant qu'avec une telle structure, le temps $\tau'$ de retour à l'état isolant est très sensiblement supérieur à l'instant $\tau$, du simple fait que le temps nécessaire pour créer des porteurs libres au sein du matériau semi-conducteur alors que celui-ci est éclairé est bien inférieur au temps $\tau'$ nécessaire pour éliminer ces porteurs lorsque l'éclairement cesse. Ce temps $\tau'$ n'est en outre pas susceptible d'être modifié par un quelconque moyen extérieur. Par suite la durée de l'impulsion électrique produite, quoique plus brève que celles produite par les moyens généralement employés, ne peut être complètement maitrisée.

C'est pourquoi le dispositif selon l'invention intègre, outre les éléments présentés sur la figure 4, des moyens complémentaires permettant de maitriser parfaitement la largeur de l'impulsion électrique produite sur l'électrode et ce, en dépit du fait que la durée du retour à l'état isolant de la pastille de matériau semi-conducteur qui fait ici fonction d'interrupteur ne peut être complètement déterminée.

L'action de ces moyens consiste à appliquer sur l'électrode, au bout d'un temps $\Delta t_0$ après la fermeture du circuit c'est-à-dire, dans la forme de réalisation préférée, après la mise en conduction de la pastille, un échelon de tension d'amplitude $-V_1$ de façon à porter quasi instantanément le potentiel de l'électrode à $V_0$. De la sorte on peut obtenir une impulsion électrique dont la durée peut être plus brève (de l'ordre de la centaine de picosecondes) que celle des impulsions produites avec des générateurs d'impulsion classiques et dont les fronts de montée et de descente sont extrêmement raids (quelques picosecondes) et de durées comparables voire sensiblement égales.

Il est à noter que de tels moyens, qui agissent directement au niveau du potentiel auquel est portée l'électrode, peuvent avantageusement être associés à des moyens pour commander la fermeture et l'ouverture de la liaison 46 de natures diverses. L'avantage procuré par la mise en oeuvre de tels moyens ne se limite donc pas au cas particulier du mode de réalisation préféré décrit précédemment dans lequel ces moyens sont constitués d'une pastille de matériau semi-conducteur et d'une source produisant des impulsions lumineuses.

D'un point de vue physique, dans le mode de réalisation préféré du dispositif selon l'invention, la production des impulsions à haute tension est donc réalisée au moyen d'une ou plusieurs pastilles de matériau semi-conducteur 42 (Silicium, Germanium, Arséniure de Gallium ou autres) a gap direct ou indirect. De tels éléments, connus pour leurs propriétés électrooptiques, deviennent conducteurs pendant une courte durée sous l'effet d'une impulsion lumineuse, 44, brève et intense, issue par exemple d'un générateur laser à impulsions femtoseconde. Par suite, la longueur d'onde $\lambda_1$ de l'impulsion lumineuse 44 est choisie afin de générer des charges libres par photoconduction dans le matériau semi-conducteur. Autrement dit, l'énergie des photons émis est déterminée de façon à être supérieure au Gap du matériau utilisé.

De la sorte, lorsque cette pastille de matériau 42 n'est pas illuminée, sa résistance électrique demeure élevée, de l'ordre de la centaine de mégohms. Inversement, lorsque la pastille est illuminée par une impulsion lumineuse intense 44 émise par la source 43, une quantité importante de charges libres, de porteurs, est libérée au sein de la pastille 42 par effet de photoconduction. La pastille passe alors d'une impédance de quelques mégohms à quelques ohms en un temps très court, typiquement inférieur à cent picosecondes. La pastille devient alors conductrice. La durée pendant laquelle le dispositif est conducteur (durée de conduction), qui correspond à la durée de vie des porteurs libres, dépend en outre de l'épaisseur de la pastille, de la nature du matériau semi-conducteur utilisé ainsi que du temps pendant lequel le semi-conducteur est illuminé ou plus largement de l'énergie lumineuse reçue.

La géométrie de la pastille semi-conductrice 42, est en pratique choisie pour éviter d'atteindre la tension de claquage du matériau, sachant qu'il est nécessaire de pouvoir établir une tension de quelques kilovolts entre les deux extrémités de la pastille lorsque celle-ci est à l'état isolant (interrupteur ouvert). Cette tension de claquage est une constante du matériau semi-conducteur, valant par exemple $3.10^5$ V/cm pour le Silicium et $4.10^5$ V/cm pour l'Arséniure de Gallium. Une épaisseur suffisante est donc nécessaire. Inversement, afin de pouvoir travailler à des fréquences de génération d'impulsion élevées, il est préférable que la pastille passe très rapidement de l'état isolant à l'état conducteur et de l'état conducteur à l'état isolant. Ceci passe par l'utilisation d'une pastille 42 d'épaisseur réduite. Par suite le choix de l'épaisseur à donner à la pastille 42 résulte d'un compromis qui est notamment fonction du matériau utilisé, le temps de conduction de la pastille dépendant notamment de la nature du matériau (temps de recombinaison des porteurs photo-induits).

Du point de vue de son fonctionnement, la pastille 42 constitue en elle-même un circuit de type RLC, illustré par la figure 5, pour lequel la résistance $R_s$ varie de quelques Mégohms lorsque la pastille n'est pas éclairée (état ouvert de l'interrupteur) à quelques ohms lorsqu'elle est éclairée (état fermé de l'interrupteur). La capacité $C_s$, typiquement de l'ordre du picofarad, est fonction de la géométrie de la pastille. L'inductance $L_s$ quant à elle est de l'ordre de quelques dizaines de picohenry. Cette pastille représente donc un circuit résonant, dont la fréquence de résonance $v_s$ ( $\nu_s \propto \sqrt{L_s \cdot C_s}^{-\frac{1}{2}}$ )

est typiquement de quelques dizaines de Gigahertz. Par suite la résistance $R_s$ doit être ajustée à l'aide de l'intensité du faisceau lumineux appliqué à la pastille afin de supprimer toute oscillation parasite de façon à pouvoir réaliser une impulsion comportant un plateau de tension le plus constant possible. Cependant, en maintenant une résistance non nulle lorsque la pastille est conductrice, on altère le temps de montée de quelques picosecondes.

Selon l'invention, la pastille de matériau 42 est donc directement en charge de production des impulsions électriques produites, de sorte que, à la différence du générateur 31 équipant un dispositif classique dont le principe est illustré par la figure 3, le générateur 41 est un générateur de tension continue ou encore en un générateur délivrant des impulsions larges qui seront découpées par l'interrupteur que constitue la pastille 42.

Il est à noter que la durée de conduction de la pastille 42, et l'évolution de la conductivité de la pastille au cours du temps de conduction détermine la largeur maximale de l'impulsion électrique appliquée à l'échantillon. Cette durée est notamment fonction de la durée de l'impulsion lumineuse 44 et de la nature du matériau de la pastille. Par ailleurs, le temps de montée minimal de l'impulsion est quant à lui fonction d'une part du taux de création des porteurs libres, et d'autre part de la structure du circuit électronique au sein duquel est inséré le dispositif. De la sorte, en adoptant la structure appropriée, un temps de montée minimal, de l'ordre de quelques picosecondes, peut avantageusement être obtenu.

En outre, la durée de vie des porteurs libres au sein de la pastille 42 détermine le temps de descente maximum de l'impulsion électrique. Par suite la durée exacte de l'impulsion ainsi que celle du temps de descente, sont maitrisées grâce aux moyens complémentaires. Cependant la vitesse de disparition des porteurs libres peut être augmentée, dans certaines applications comme celle illustrée par la figure 12 et décrite dans la suite de la description, par application d'une seconde impulsion lumineuse sur la pastille 42, cette seconde impulsion lumineuse a une longueur d'onde v' différente de celle utilisée pour mettre la pastille en conduction. Le but est dans ce cas d'obtenir une impulsion électrique présentant un front de descente d'une durée du même ordre que celle du front de montée.

La longueur d'onde de l'impulsion lumineuse 45 est par ailleurs choisie en fonction du matériau utilisé, de façon à produire l'effet photoconducteur. L'intensité lumineuse de la source 43 employée doit également être choisie afin de réduire suffisamment la résistance électrique de la pastille, lorsque celle-ci est à l'état conducteur (interrupteur fermé).

Ainsi, de par la taille des impulsions générées et la raideur des fronts de montée et de descente qu'il est possible d'obtenir, le dispositif selon l'invention, en particulier dans le mode de réalisation préféré plus particulièrement décrit dans le texte qui précède, remplace avantageusement les dispositifs générateurs d'impulsions électriques utilisés usuellement pour les sondes atomiques (cf. figure 3).

En outre, l'utilisation d'une pastille de matériau semi-conducteur en tant que commutateur permet d'intégrer la partie commutation du dispositif ainsi réalisé directement dans l'enceinte sous vide de la sonde, de sorte que le commutateur peut avantageusement être placé au voisinage immédiat du point d'application de l'impulsion. On peut ainsi mieux maitriser l'adaptation du circuit de commutation et par conséquent la forme de l'impulsion produite.

Les variantes du dispositif selon l'invention, dans le mode de réalisation préféré, pour un usage en tant que générateur d'impulsions d'évaporation au sein d'une sonde atomique, sont diverses et dépendent en particulier de l'agencement de l'électrode 32 vis-à-vis de l'échantillon 33 et de la façon de réaliser la liaison électrique globale 46 permettant d'acheminer l'impulsion électrique produite jusqu'à l'électrode 32 et à l'échantillon 33. Différentes variantes de réalisations sont présentées à titre d'exemples non limitatifs dans la suite de la description. Ces variantes de réalisation prennent en particulier en compte le fait que l'ensemble formé par la contre-électrode et la pointe échantillon constitue un circuit de type RLC illustré par la figure 6, dont la résistance $R_p$ varie de sensiblement zéro ohms au millier de Mégohms et dont la capacité $C_p$ et l'inductance $L_p$ sont respectivement de l'ordre du centième de picofarad et de l'ordre du nanohenry. Ce circuit présente une fréquence de résonance $v_p$ ($\nu_p \propto \sqrt{L_p \cdot C_p}^{-1/2}$) dont la durée caractéristique est de l'ordre de 1 à 5 ps. Par suite le dispositif selon l'invention doit permettre la réalisation d'impulsions dont les fronts de montée et de descente ont des durées supérieures à cette valeur de façon à éviter toute oscillation résonante.

Les figures 7 à 10 illustrent une première variante du dispositif selon l'invention, ainsi que le principe de fonctionnement général de l'invention.

Les figures 7 et 8 présentent de manière schématique un premier mode de réalisation du dispositif selon l'invention et permettent d'en détailler le fonctionnement. Ce premier mode de réalisation, ainsi que les autres modes présentés dans la suite de la description, sont bien sur présenté à titre d'exemples non limitatifs.

Dans cette variante de réalisation, un générateur de tension 71, d'impédance $R_0$, est relié à une électrode 73 en forme d'anneau au moyen d'une ligne de transmission 72 de longueur $L_0$. L'électrode est située en regard de l'extrémité de l'échantillon 76 à analyser, échantillon en forme de pointe, lui-même porté à un potentiel $V_0$.

La pastille semi-conductrice 75 est placée à la base de l'anneau 73, lui-même est relié à une impédance de charge $Z_c$, 74, qui ferme la ligne 72.

La ligne de propagation 72 présente une impédance caractéristique égale à l'impédance de charge $Z_c$, 74, typiquement de l'ordre de la centaine d'ohms, tandis que la valeur de la résistance $R_0$ du générateur 71 est choisie pour maximiser la réflexion des ondes de tension. La valeur de $R_0$ est en outre inférieure à l'impédance $R_{off}$ de la pastille 75 à l'état non-conducteur, typiquement quelques mégohms, de façon à obtenir une tension maximale aux bornes de la pastille. La relation entre les différentes impédances s'établit donc comme suit:

$$R_0 \gg R_{off} \gg Z_c$$

L'évaporation par effet de champ de quelques atomes de l'échantillon 76 se produit lorsque l'anneau 73, initialement à un potentiel proche du potentiel de référence est porté à une valeur négative par rapport à cette référence. La maitrise du processus d'évaporation, qui conditionne la résolution de la sonde, suppose que ce potentiel ne soit appliqué à l'anneau que pendant un instant très bref de façon à ce que ne soient évaporés que quelques atomes.

La figure 7 présente le dispositif, en l'absence de stimulation. La pastille de semi-conducteur 74 est alors non-conductrice, de sorte qu'elle présente une impédance $R_{off}$ élevée. L'anneau 73 est alors quant à lui placé à un potentiel sensiblement égal au potentiel de référence, le potentiel de masse par exemple ($V_{anneau} \sim 0$). De la sorte, l'échantillon 76 étant porté au seul potentiel $V_0$, aucune évaporation ne se produit.

La figure 8, en revanche, présente le dispositif en présence d'une stimulation. Cette stimulation prend la forme d'une impulsion lumineuse qui déclenche le dispositif en rendant conductrice la pastille 75 de matériau semi-conducteur de telle sorte que cette dernière présente alors, pendant un temps donné, une résistance $R_{on}$ de faible, voire très faible, valeur.

Par suite, cette variation de la valeur de la résistance R de la pastille 75 se traduit par l'apparition à un instant tel d'un échelon de tension 82, de valeur V qui se propage sur la ligne, avec une vitesse $v_s$, en direction du générateur 71 d'une part et en direction de la charge $Z_c$, 74, d'autre part. Compte tenu du fait que l'impédance de la pastille 75 est sensiblement nulle et que les valeurs de l'impédance de charge 74 et de l'impédance caractéristique de la ligne 72 sont sensiblement égales à la même valeur $Z_c$, l'amplitude V de l'échelon de tension est sensiblement égale à $-V_p/2$. Par ailleurs, le temps de montée $\tau$ de cet échelon est directement fonction du temps mis par le matériau pour devenir conducteur sous l'effet de l'impulsion lumineuse. Il est de l'ordre de la picoseconde.

En arrivant à l'entrée du générateur 71 l'échelon de tension 83 se réfléchi sur $R_0$ et produit, compte tenu de la valeur élevée de la résistance $R_0$ par rapport à celle de l'impédance $Z_c$, un échelon 84 de signe opposé d'amplitude sensiblement égale à $V_p/2$, qui se propage à sont tour sur la ligne 72. de sorte que, après un temps $\Delta t$ sensiblement égal à $2 \cdot L_0/vs$, vs représentant la vitesse de propagation du signal le long de la ligne 74, l'échelon incident 83 et l'échelon réfléchi 84 s'additionnent au niveau de l'anneau 73. Les tensions appliquées à l'anneau 73 s'annulent alors en un temps (temps de descente) équivalent au temps de montée. Par suite, du fait de la

longueur $L_0$ de la ligne 72 et du fait que l'anneau est situé au voisinage de la pastille 75, l'anneau 73 se voit appliquer tout d'abord un échelon de tension V avec un temps de montée T puis, au bout du temps $\Delta t_0$, un échelon de tension inverse -V avec un temps de descente égal lui aussi à $\tau$. On applique ainsi à l'anneau 73 une impulsion d'amplitude $-V_p/2$, de durée $\Delta t_0$ présentant des fronts de montée et de descente de durée $\tau$.

Il est à noter que les valeurs des paramètres T et $\Delta t_0$ qui définissent la forme et la durée de l'impulsion appliquée à l'anneau 73 peuvent avantageusement être maitrisés. En effet la durée T des fronts de montée et de descente est directement fonction du matériau semi-conducteur employé et de l'intensité de l'impulsion lumineuse 81 appliquée. La durée $\Delta t_0$ est quant à elle déterminée par la nature et la longueur de la ligne de transmission 74.

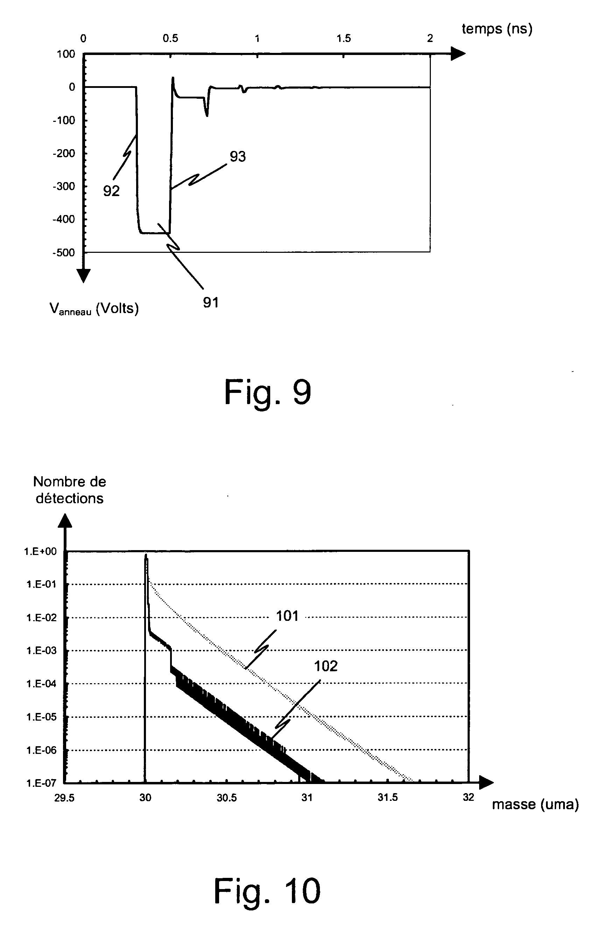

Les figures 9 et 10 illustrent au travers de résultats de simulation, les effets avantageux de la mise en oeuvre du dispositif selon l'invention. Pour cette simulation, la pastille de semi-conducteur 75 est modélisée par un circuit RLC dont la résistance $R_{on}$ sous éclairement laser vaut 10 ohms et dont la résistance $R_{off}$ hors éclairement vaut 1 mégohm. L'inductance L est ici fixée à $5 \cdot 10^{-12}$ Henry et la capacité C à $10^{-13}$ Farads. En outre, la tension $V_p$ délivrée par le générateur 71 est fixée à 1000 volts et sa résistance $R_0$ à 33 kilohms. Par ailleurs, l'impédance $Z_c$ est fixée à 100 ohms et la longueur de la ligne de transmission 72 à 2 centimètres. Enfin, la vitesse de propagation sur la ligne 72 est fixée à 200 mètres par microseconde et le temps de création des porteurs dans le semi-conducteur constituant la pastille 75 est ici fixé à 2 picosecondes.

L'oscillogramme de la figure 9 permet de constater que, lorsqu'on illumine la pastille de semi-conducteur avec une impulsion lumineuse, on obtient, avec un tel dispositif, la production d'une impulsion électrique 91 d'une durée sensiblement égale à 200 picosecondes présentant des fronts de montée 92 et de descente 93 très brefs et de durées égales, de l'ordre de quelques picosecondes, ainsi qu'une amplitude proche de Vp/2. On constate également que la durée de l'impulsion produite ne dépend avantageusement que du temps de propagation de l'échelon de tension le long de la ligne de propagation 72.

L'illustration de la figure 10 présente sur un même diagramme, pour un échantillon homogène constitué d'éléments de masse égale à 30 uma, les spectres de masse 101 et 102 obtenus respectivement en utilisant un générateur d'impulsions de type connu de l'art antérieur et un générateur d'impulsions réalisé au moyen du dispositif selon l'invention tel qu'illustré par les figures 7 et 8. Comme l'illustre la figure, la mise en oeuvre du dispositif selon l'invention permet avantageusement de produire des impulsions dont les caractéristiques améliorent les performances globales de la sonde atomique dans laquelle celui-ci est intégré. Cette amélioration en terme de résolution en masse se matérialise sur la figure par une atténuation du pied du spectre d'au moins un ordre de grandeur par rapport au spectre du même échantillon obtenu en utilisant des moyens classiques connus.

La figure 11 présente de manière schématique une deuxième variante de réalisation du dispositif selon l'invention.

Dans cette variante, le dispositif générateur d'impulsions d'évaporation est agencé de façon à ce que l'échantillon à analysé soit directement intégré à l'ensemble en lieu et place de l'électrode en anneau 73. La référence de potentiel du dispositif est portée au potentiel $V_0$ appliqué seulement à l'échantillon dans le mode de réalisation précédent, l'ensemble dispositif plus échantillon étant ainsi porté à un potentiel Commun égal à $V_0$.

Le générateur de tension est en outre configuré pour fournir une tension $+V_p$ susceptible de venir s'ajouter à la tension $V_0$ appliquée à l'échantillon.

Ainsi, au repos, c'est-à-dire en l'absence d'éclairement, la pastille de matériau semi-conducteur 74 est alors non-conductrice, de sorte qu'elle présente une impédance $R_{off}$ élevée. L'échantillon 76 est alors porté à un potentiel sensiblement égal au potentiel de référence $V_0$ de sorte qu'aucune fusion ne se produit.

En revanche en fonctionnement, c'est-à-dire lorsque la pastille la pastille de matériau semi-conducteur 74 est soumise à un éclairement et présente de ce fait une impédance $R_{on}$ très faible, l'échantillon 76 se trouve soumis à une impulsion de tension qui le porte pendant toute sa durée à un potentiel sensiblement égal à $V_0+V_p$ qui provoque l'évaporation recherchée.

Dans cette deuxième variante de mise réalisation, comme dans la précédente, la durée de l'impulsion est déterminée par la longueur de la ligne 72 qui permet d'appliquer la tension délivrée par le générateur 71 à l'échantillon 76. On obtient donc, en employant ce deuxième montage dans une sonde atomique, les mêmes avantages en terme de résolution que ceux obtenus au moyen du montage précédent.

La figure 12 présente de manière schématique une troisième variante de réalisation du dispositif selon l'invention.

La variante décrite ici diffère des précédentes en ce que la durée de l'impulsion électrique produite ainsi que les durées de ses fronts montant et descendant sont obtenues simplement en agissant sur la pastille de matériau semi-conducteur 75.

La pastille 75 est rendue conductrice ($R=R_{on}$) par application d'une première impulsion lumineuse 121 puis rendu à nouveau non-conductrice ($R=R_{off}$), au bout d'un instant $\Delta t_0$, par application d'une seconde impulsion lumineuse 122, de longueur d'onde différente de la première impulsion lumineuse. On produit ainsi une impulsion électrique de durée $\Delta t_0$.

L'action de la première impulsion lumineuse 121 consiste, comme précédemment, à créer des porteurs libres photo-induits dans le matériau semi-conducteur. La seconde impulsion lumineuse 122, quant à elle, agit sur le semi-conducteur en activant les sites de recombinaison du semi-conducteur de façon à provoquer la destruction quasi instantanée des porteurs libres. Selon ce mode de réalisation, le matériau semi-conducteur constituant la pastille est choisi de façon à réagir aux deux longueurs d'ondes considérées.

Selon l'invention, l'intervalle de temps $\Delta t_0$ séparant les deux impulsions lumineuses 121 et 122 est réalisé par tout moyen connu, une ligne à retard optique par exemple.

On obtient ainsi une impulsion électrique dont la durée est fonction de l'intervalle de temps séparant les deux impulsions lumineuses, et dont les fronts montant et descendant ont des durées, de l'ordre de quelques picosecondes, qui dépendent uniquement du temps de mise en conduction du semi-conducteur et du temps de recombinaison des porteurs libres créés par la première impulsion lumineuse.

**Revendications**

1. Sonde atomique tomographique comportant des moyens pour appliquer une impulsion électrique d'évaporation d'amplitude $V_p$, de durée $\Delta t_0$ sur un échantillon porté à un potentiel $V_0$, **caractérisée en ce que** ces moyens comportent:

   - une électrode portée à un potentiel initial $V_i$, configurée et agencée pour appliquer l'impulsion électrique sur l'échantillon;
   - un générateur de tension capable de produire la tension nécessaire à la production d'une impulsion d'amplitude $V_p$, le générateur de tension étant relié à l'électrode par l'intermédiaire d'une liaison électrique pouvant être ouverte ou fermée;
   - des moyens pour commander la fermeture de la liaison électrique en en un temps $\tau$ donné de façon à appliquer un échelon de tension $V_p$ sur l'électrode, ces moyens comportant une pastille de matériau semi-conducteur placée sur la liaison électrique entre le générateur et l'électrode, au voisinage de l'électrode et une première source émettant des impulsions lumineuses de longueur d'onde $\lambda_1$ sur la pastille de semi-conducteur, ladite pastille devenant conductrice et fermant la liaison électrique lorsqu'elle est illuminée par une impulsion lumineuse de longueur d'onde $\lambda_1$, la durée de conduction étant fonction de la durée de l'impulsion lumineuse appliquée;
   - des moyens pour appliquer sur l'électrode, au bout d'un temps $\Delta t_0$ après la fermeture de la liaison électrique, un échelon de tension d'amplitude ($-V_p$) de façon à porter l'électrode au potentiel $V_i$, lesdits moyens étant configurés pour que l'échelon de tension soit appliqué en un temps $\tau'$ sensiblement égal au temps $\tau$.

**2.** Sonde atomique tomographique selon la revendication 1, **caractérisée en ce que** les moyens pour appliquer sur l'électrode au bout d'un temps $\Delta t_0$ après la fermeture du circuit, un échelon de tension d'amplitude -Vp sont constitués par une ligne de transmission d'impédance caractéristique $Z_c$ reliant le générateur à la pastille, terminée en aval de l'électrode par une impédance égale à $Z_c$.

**3.** Sonde atomique tomographique selon la revendication 2, **caractérisée en ce que** la longueur $L_0$ de la ligne de transmission est déterminée par la valeur de l'intervalle de temps $\Delta t_0$ considéré, intervalle de temps égal à la durée de l'impulsion électrique produite.

**4.** Sonde atomique tomographique selon la revendication 1, **caractérisée en ce que** les moyens pour appliquer sur l'électrode au bout d'un temps $\Delta t_0$ après la fermeture du circuit, un échelon de tension d'amplitude -$V_p$ sont constitués par une seconde source émettant des impulsions lumineuses de longueur d'onde $\lambda_2$ sur la pastille de semi-conducteur, ladite pastille devenant isolante et ouvrant la liaison électrique lorsqu'elle est illuminée par une impulsion lumineuse de longueur d'onde $\lambda_2$.

**5.** Sonde atomique tomographique selon la revendication 4, **caractérisée en ce que** l'intervalle de temps $\Delta t_0$ séparant l'émission d'une impulsion lumineuse de longueur d'onde $\lambda_1$ de l'émission d'une impulsion lumineuse de longueur d'onde $\lambda_2$, détermine la durée de l'impulsion électrique produite.

**6.** Sonde atomique tomographique selon l'une quelconque des revendications 1 à 5, **caractérisée en ce que** l'électrode sur laquelle est produite l'impulsion électrique est positionnée en regard de l'extrémité de l'échantillon au niveau de laquelle l'évaporation est attendue.

**7.** Sonde atomique tomographique selon l'une quelconque des revendications 1 à 5, **caractérisée en ce que** l'électrode sur laquelle est produite l'impulsion électrique est constituée par l'échantillon lui-même.

**Claims**

**1.** A tomography atom probe comprising means for applying an electrical evaporation pulse of amplitude $V_p$ and of duration $\Delta t_0$ to a sample that is taken to a potential Vo, **characterised in that** said means comprise:

- an electrode that is taken to an initial potential $V_i$ and is configured and arranged to apply the electrical pulse to the sample;
- a voltage generator that is designed to produce the voltage necessary for the production of a pulse of amplitude $V_p$, the voltage generator being connected to the electrode by means of an electrical connection that can be open or closed;
- means for controlling the closure of the electrical connection at a given time $\tau$ so as to apply a voltage step $V_p$ to the electrode, said means comprising a chip of semi-conductive material that is placed on the electrical connection between the generator and the electrode, in the vicinity of the electrode, and a first source emitting light pulses of wavelength $\lambda_1$ to the semi-conductive chip, said chip becoming conductive and closing the electrical connection when it is illuminated by a light pulse of wavelength $\lambda_1$, the duration of conduction being a function of the duration of the applied light pulse;
- means for applying a voltage step of amplitude -$V_p$ to the electrode, at the end of a time $\Delta t_0$ after closure of the electrical connection, so as to take the electrode to the potential $V_i$, said means being configured so that the voltage step is applied at a time $\tau'$ that is essentially equal to the time $\tau$.

**2.** The tomography atom probe according to claim 1, **characterised in that** the means for applying a voltage step of amplitude -$V_p$ to the electrode, at the end of a time $\Delta t_0$ after closure of the circuit, are constituted by a transmission line with a characteristic impedance $Z_c$ that connects the generator to the chip, terminated downstream of the electrode by an impedance that is equal to $Z_c$.

**3.** The tomography atom probe according to claim 2, **characterised in that** the length $L_0$ of the transmission line is determined by the value of the considered time interval $\Delta t_0$, which time interval is equal to the duration of the electrical pulse produced.

**4.** The tomography atom probe according to claim 1, **characterised in that** the means for applying a voltage step of amplitude -$V_p$ to the electrode, at the end of a time $\Delta t_0$ after closure of the circuit, are constituted by a second source emitting light pulses of wavelength $\lambda_2$ to the semi-conductive chip, said chip becoming insulating and opening the electrical connection when it is illuminated by a light pulse of wavelength $\lambda_2$.

**5.** The tomography atom probe according to claim 4, **characterised in that** the time interval $\Delta t_0$ that separates the emission of a light pulse of wavelength $\lambda_1$ from the emission of a light pulse of wavelength $\lambda_2$ determines the duration of the electrical pulse produced.

**6.** The tomography atom probe according to any one of claims 1 to 5, **characterised in that** the electrode on which the electrical pulse is produced is positioned facing the end of the sample on which the evaporation is expected.

**7.** The tomography atom probe according to any one of claims 1 to 5, **characterised in that** the electrode on which the electrical pulse is produced is constituted by the sample itself.

**Patentansprüche**

**1.** Tomografie-Atomsonde, die Mittel zum Anlegen eines elektrischen Verdampfungsimpulses mit Amplitude $V_p$, mit einer Dauer $\Delta t_0$, an eine auf ein Potential $V_0$ gebrachte Probe umfasst, **dadurch gekennzeichnet, dass** die Mittel Folgendes umfassen:

- eine auf ein Anfangspotential $V_i$ gebrachte Elektrode, die zum Anlegen eines elektrischen Impulses an die Probe konfiguriert und angeordnet ist;
- einen Spannungsgenerator zum Erzeugen der Spannung, die zur Erzeugung eines Impulses mit Amplitde $V_p$ nötig ist, wobei der Spannungsgenerator mit der Elektrode über eine elektrische Verbindung verbunden ist, die geöffnet oder geschlossen werden kann;
- Mittel zum Steuern des Schließens der elektrischen Verbindung zu einem Zeitpunkt $\tau$, der so festgelegt ist, dass eine Spannungsstufe $V_p$ an die Elektrode angelegt wird, wobei diese Mittel einen Chip aus einem Halbleitermaterial, der auf der elektrischen Verbindung zwischen dem Generator und der Elektrode nahe der Elektrode platziert ist, und eine erste Quelle umfassen, die Lichtimpulse der Wellenlänge $\lambda_1$ auf den Halbleiterchip emittiert, wobei der Chip leitend wird und die elektrische Verbindung schließt, wenn sie von einem Lichtimpuls der Wellenlänge $\lambda_1$ beleuchtet wird, wobei die Dauer der Leitung von der Dauer des angelegten Lichtimpulses abhängig ist;
- Mittel, um an die Elektrode, am Ende einer Zeit $\Delta t_0$ nach dem Schließen der elektrischen Verbindung, eine Spannungsstufe mit Amplitude ($-V_p$) anzulegen, um die Elektrode auf das Potential $V_i$ zu bringen, wobei die Mittel so konfiguriert sind, dass die Spannungsstufe in einer Zeit $\tau'$ im Wesentlichen gleich der Zeit $\tau$ angelegt wird.

**2.** Tomografie-Atomsonde nach Anspruch 1, **dadurch gekennzeichnet, dass** die Mittel zum Anlegen einer Spannungsstufe mit Amplitude -Vp an die Elektrode am Ende einer Zeit $\Delta t_0$ nach dem Schließen der Schaltung von einer den Generator mit dem Chip verbindenden Übertragungsleitung mit einer charakteristischen Impedanz $Z_c$ gebildet werden, die unterhalb der Elektrode mit einer Impedanz von gleich $Z_c$ endet.

**3.** Tomografie-Atomsonde nach Anspruch 2, **dadurch gekennzeichnet, dass** die Länge $L_0$ der Übertragungsleitung durch den Wert des Intervalls der betrachteten Zeit $\Delta t_0$ bestimmt wird, wobei das Zeitintervall gleich der Dauer des erzeugten elektrischen Impulses ist.

**4.** Tomografie-Atomsonde nach Anspruch 1, **dadurch gekennzeichnet, dass** die Mittel zum Anlegen einer Spannungsstufe von Amplitude -$V_p$ an die Elektrode am Ende einer Zeit $\Delta t_0$ nach dem Schließen der Schaltung durch eine zweite Quelle gebildet werden, die Lichtimpulse der Wellenlänge $\lambda_2$ auf den Halbleiterchip emittieren, wobei der Chip isolierend wird und die elektrische Verbindung öffnet, wenn sie durch einen Lichtimpuls mit Wellenlänge $\lambda_2$ beleuchtet wird.

**5.** Tomografie-Atomsonde nach Anspruch 4, **dadurch gekennzeichnet, dass** das Zeitintervall $\Delta t_0$, das die Emission eines Lichtimpulses von Wellenlänge $\lambda_1$ von der Emission eines Lichtimpulses von Wellenlänge $\lambda_2$ trennt, die Dauer des erzeugten elektrischen Impulses bestimmt.

**6.** Tomografie-Atomsonde nach einem der Ansprüche 1 bis 5, **dadurch gekennzeichnet, dass** die Elektrode, auf der der elektrische Impuls erzeugt wird, gegenüber dem Ende der Probe positioniert ist, wo die Verdampfung erwartet wird.

**7.** Tomografie-Atomsonde nach einem der Ansprüche 1 bis 5, **dadurch gekennzeichnet, dass** die Elektrode, auf der der elektrische Impuls erzeugt wird, durch die Probe selbst gebildet wird.

Nombre de
détections

Fig. 1

Nombre de
détections

Fig. 2

Art Antérieur

Fig. 3

Fig. 4

Fig. 5

Fig. 6

Fig. 7

Fig. 8

Fig. 9

Fig. 10

Fig. 11

Fig. 12

**RÉFÉRENCES CITÉES DANS LA DESCRIPTION**

**Documents brevets cités dans la description**

- JP 2007273401 A